Europäisches Patentamt

European Patent Office

Office européen des brevets

(11) Publication number: **0 354 708**
**A2**

## EUROPEAN PATENT APPLICATION

(21) Application number: 89307798.2

(51) Int. Cl.⁴: **H01L 25/065 , H01L 23/538**

(22) Date of filing: 01.08.89

(30) Priority: 08.08.88 US 229685
09.08.88 US 230203

(43) Date of publication of application:
**14.02.90 Bulletin 90/07**

(84) Designated Contracting States:
**DE FR GB IT NL**

(71) Applicant: **TEXAS INSTRUMENTS
INCORPORATED
13500 North Central Expressway
Dallas Texas 75265(US)**

(72) Inventor: **Johnson, Randall E.
2210 Big Bend
Carrollton Dallas 75007(US)**
Inventor: **Drumm, James M.
9340 Skillman Apt. No.1416
Dallas Texas 75243(US)**

(74) Representative: **Abbott, David John et al
Abel & Imray Northumberland House 303-306
High Holborn
London, WC1V 7LH(GB)**

(54) **General three dimensional packaging.**

(57) A three dimensional package having at least one semiconductor chip 40 having input/output conductive pads 42 along its periphery includes a dielectric carrier 44 over at least a portion of the chip and a plurality of conductors 46 mounted on the carrier. The plurality of conductors 46 are mounted within the periphery of the chip with one end 48 connected to the conductive pads 42 and with the other end 53 of the plurality of conductors exiting from the same side 50 of the chip 40. The plurality of conductors 53 exiting from the same side 50 are electrically coupled to an interconnect substrate.

Fig. 3

## GENERAL THREE DIMENSIONAL PACKAGING

This invention relates to packaging, and, more particularly to a method and apparatus for achieving high density, three dimensional packaging of semiconductors.

Military and commercial systems today are placing increasing requirements on packaging density and efficiency. As applied to memory devices, for example, these requirements often are amplified due to the large number of devices necessary for system operation.

Prior art packaging systems contemplate placing a plurality of memories on a printed circuit board in a planar manner or the hybridization of memories (placing more than one chip in a package). This has been implemented using wire bond, tape automated bonding (TAB) and flip chips to access the electrical input/output (I/O) pads on the chip. Significant increases in packaging density are not possible through hybridization.

Accordingly it is an object of the present invention to provide a method and system for interconnecting semiconductor (S/C) chips in a three dimensional (3D) configuration to allow high density packaging.

Another object of the present invention is to provide a method and system for interconnecting a plurality of 3D packages on an interconnect substrate which reduces the interconnect substrate area required and enhances the electrical performance.

Another object of the present invention is to develop an efficient, economical, mass producible technology for the very dense packaging of semiconductor chips.

Another object of the present invention is to provide a 3D packaging technology based on orthogonal assembly of tape automated bonded (TAB) semiconductor chips.

Other objects and features of the invention will become more readily understood from the following detailed description and appended claims when read in conjunction with the accompanying drawings, in which like reference numerals designate like parts throughout the figures thereof, and in which:

Figures 1A and 1B illustrate a prior art packaging arrangement.

Figure 2 illustrates a 3D packaging arrangement according to the present invention.

Figure 3 illustrates an exploded view of the 3D package shown in Figure 2.

Figures 4A and 4B illustrate a first and second method to interconnect the carrier/conductors to the electrical pads on the semiconductor chip.

Figure 5 illustrates the completed basic building block of the 3D packaging arrangement according to the present invention.

Figure 6 illustrates a plurality of the building blocks shown in Figure 5 stacked in a laminated package.

Figure 7 illustrates the laminated package of Figure 6 after encapsulation and polishing.

Figure 8 illustrates a plurality of 3D packages attached to a daughterboard and an exploded view of a solder joint.

Figure 9 illustrates a cross-sectional enlargement of one of the 3D packages and daughterboard of Figure 8.

Figure 10 illustrates a system package which includes a plurality of daughterboards shown in Figure 9.

Figure 11 illustrates the packaging steps required to fabricate a 3D package according to the present invention.

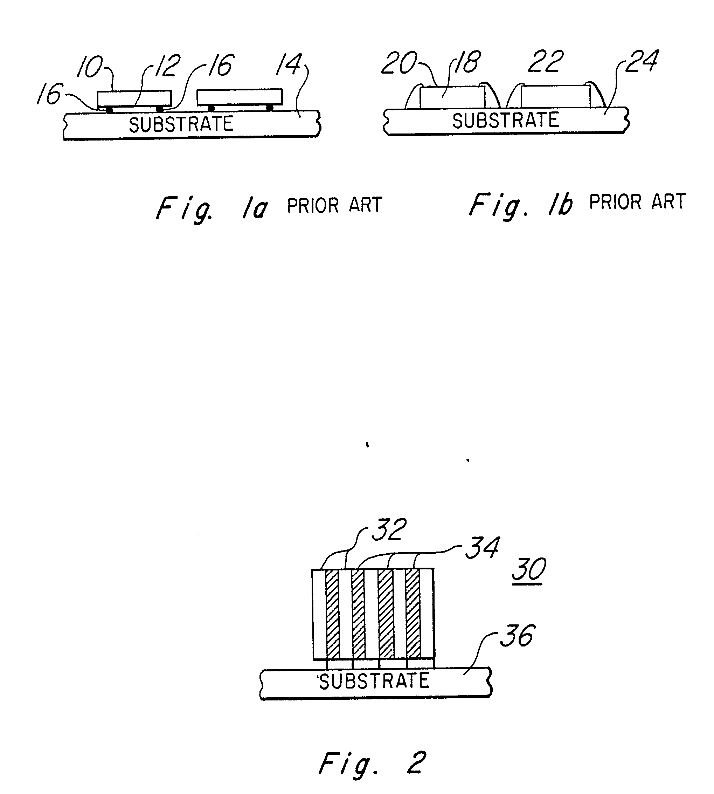

Referring now to Figure 1A, there is illustrated a prior art semiconductor chip 10 having its active surface 12 in proximity to an interconnect substrate 14. In Figure 1A semiconductor chip 10 is a flip chip memory which interconnects to substrate 14 through electrical connections 16.

In similar matter, it can be seen in the prior art embodiment of Figure 1B that semiconductor chip 18 has its active surface 20 facing away from substrate 24, and, therefore conductors 22 are used to electrically interconnect the active surface 20 of chip 18 with the interconnect substrate 24. As can be seen in both prior art embodiments of Figures 1A and 1B, the active surfaces 12 and 20 are restricted to a single plane parallel to substrates 14 and 24, respectively, and thereby overlays a large portion of the interconnect substrate, resulting in lower package densities.

Referring now to Figure 2 there is illustrated a three dimensional (3D) package 30 constructed according to the present invention which is based on the stacking of S/C chips 32 while accessing the electrical I/O pads on chips 32 with a tape automated bonding lead frame 34. Through stacking of the S/C chips 32, the active surfaces of the interconnected chips 32 are no longer restricted to a single plane (as illustrated in Figures 1A and 1B) with respect to the interconnect substrate 36. This approach results in a 45-1 increase in packaging over the best of hybridized surface mount and a 285-1 increase over dual-in-line (DIP) technology. A more detailed explanation of the invention follows.

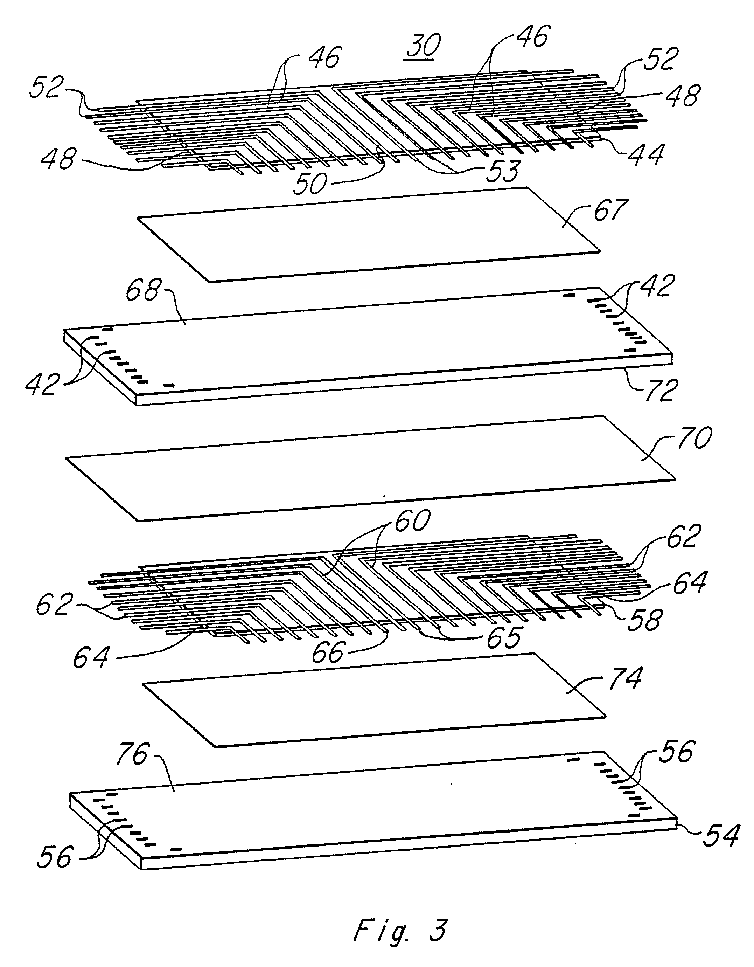

Figure 3 illustrates an exploded view of the 3D package 30 illustrated in Figure 2. A first semiconductor chip 40, for example, a 256K DRAM memory chip, has electrical contact pads 42 along its periphery. A first dielectric carrier 44 overlays at least a portion of chip 40 and may be made of a polymide tape or polyester, by way of example. A plurality of first conductors 46 are mounted to the first dielectric carrier 44 and extend past edges 48 and edge 50. The ends 52 of conductors 46 are electrically connected, for example, by thermal compression bonding, to electrical I/O pads 42 on the first S/C chip 40. The other ends 53 extend past edge 50 and exit from the same side of the package.

In a similar manner in Figure 3, a second semiconductor chip 54 is in alignment with the first semiconductor chip 40 and has electrical conductive I/O pads 56 located along its periphery. A second dielectric carrier 58 has a second plurality of conductors 60 mounted thereto, the ends 62 of which extend past the edge 64 of the carrier 58. The other ends 65 of conductor 60 extend past the edge 66 of carrier 58. The ends 62 of conductor 60 are electrically connected to the I/O pads 56 of chip 54. The other ends 53 of conductors 46 on carrier 44 exit in the same direction as the conductor ends 65 of conductor 60 on carrier 58. A first dielectric spacer 67 may be interposed between conductors 46 and the active surface 68 of chip 40. Dielectric spacer 67 may be an adhesive which is thermally conductive, an epoxy, or may be an air space. In like manner, a second dielectric spacer 70 may be positioned between the non-active surface 72 and the second dielectric carrier 58 and conductors 60. A third dielectric spacer 74 may be positioned between the active surface 76 of chip 54 and the conductors 60 on dielectric carrier 58.

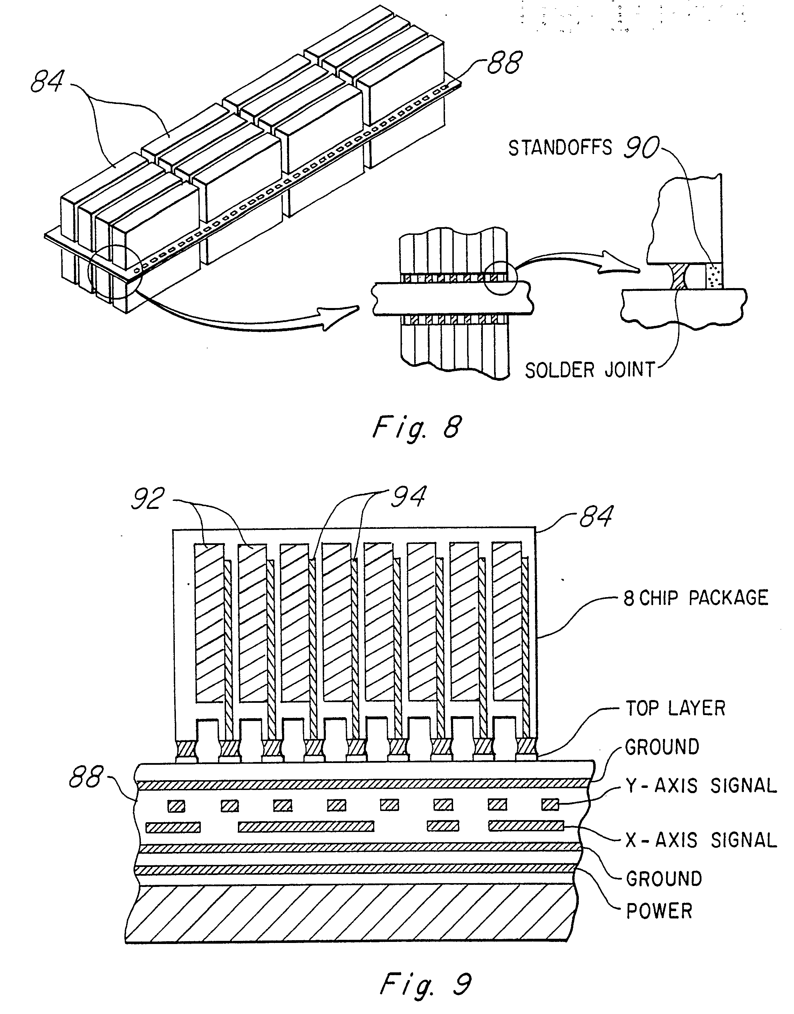

The configuration illustrated in Figure 3 may be repeated for a plurality of chips and dielectric carriers/conductors in order to build up a 3D package (such as in Figure 9, hereinafter described). It will be noted that the routing of conductors 46 and 60 on dielectric carriers 44 and 58, respectively, will produce the signals present on pads 42 and 56 on a single side of the 3D package 30.

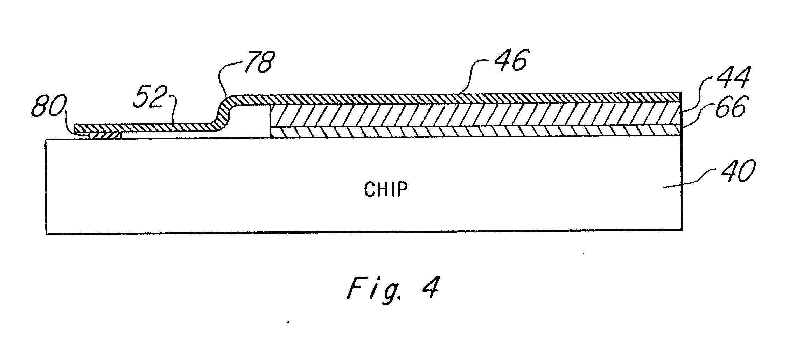

Figure 4A illustrates a "conductor up" configuration to mate the carrier 44/conductors 46 with the chip 40. In Figure 4A, conductors 46 are "up" such that the dielectric carrier 44 is positioned between conductors 46 and a dielectric spacer 66, which, as mentioned above, may be epoxy or an adhesive. Dielectric carrier 44 may be a polymide tape. As a result of conductor 46 being located on top, a small bend 78 is formed to to ensure good electrical connection between end 52 of conductor 46 and gold bump 80. Electrical bumps 80 are formed over pads 42 (shown in Figure 3); these bumps may be formed of gold and are electrically connected to conductor ends 52 by thermal compressive bonding, by way of example. Conductors 46 may be formed of gold plated copper.

Figure 4B illustrates a "conductor down" configuration (using similar numeral designations to Figure 4A) to mate the carrier 44/conductors 46 with the chip 40. In Figure 4B, conductors 46 are "down" or underneath the dielectric spacer 44. Conductors 46 are sandwiched between carrier 44 and a dielectric spacer 66, which, as mentioned above, may be epoxy or an adhesive. Dielectric carrier 44 may be a polymide tape. Electrical bumps 80 are formed over pads 42 (shown in Figure 3); these bumps may be formed of gold and are electrically connected to conductor ends 52 by thermal compressive bonding, by way of example. Conductors 46 may be formed of gold plated copper.

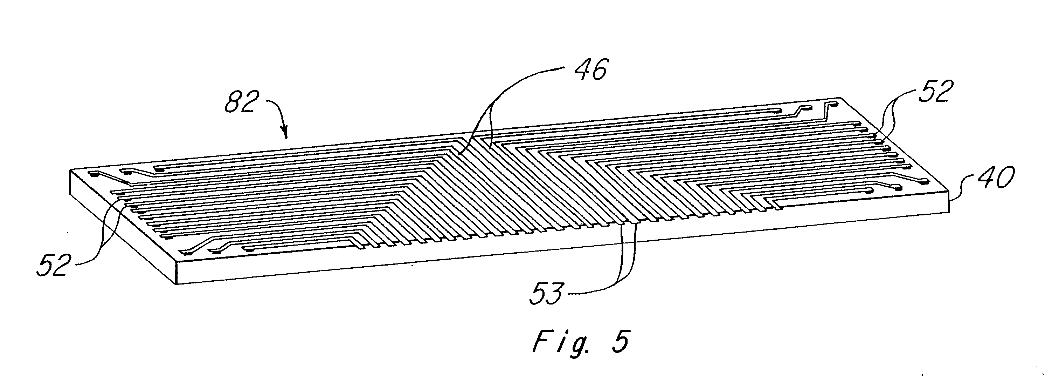

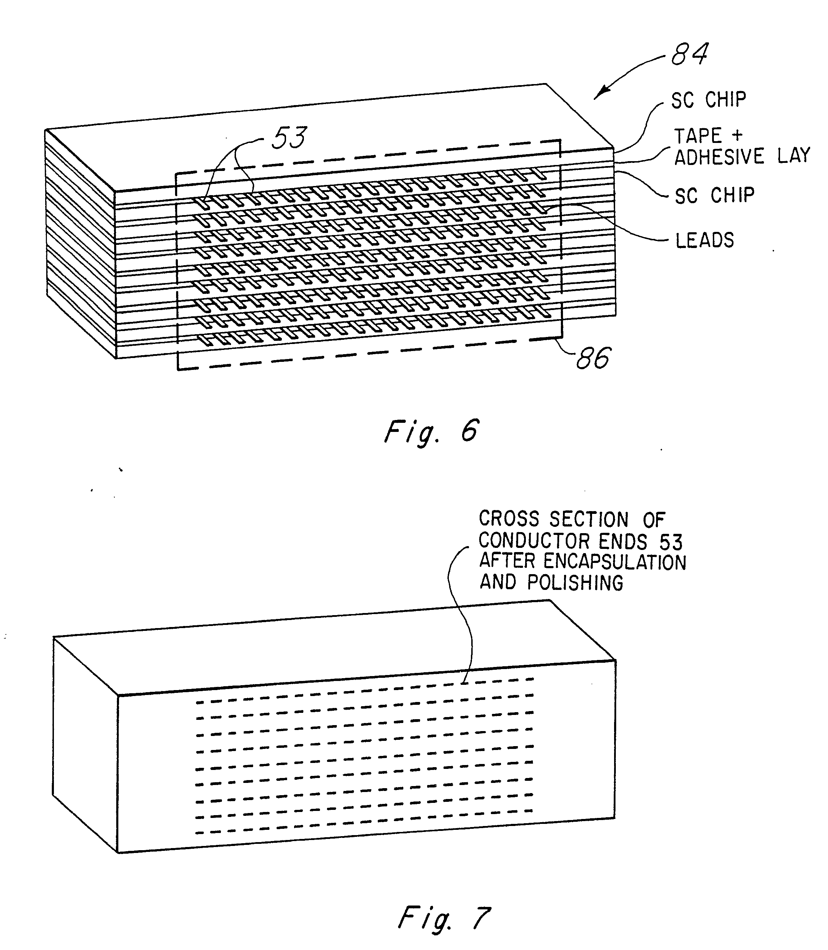

Figure 5 illustrates a semiconductor chip 40, which has been pretested on TAB tape to enhance assembly yield, after the ends 52 of conductors 46 have been bonded to bumps 80 (as shown in Figures 4A and 4B) and after the ends 52 and 53 have been cut or excised. The structure of Figure 5 represents the basic building block 82 of the 3D packaging system. A plurality of these building blocks 82 are laminated together with, for example, a thermally conductive adhesive, such as dielectric spacer 70 in Figure 3, to form a 3D package 84 as illustrated in Figure 6. When the building blocks 82 (Figure 5) are laminated together, the leads 53 on dielectric carrier 44 form an array 86 on a single side of the 3D package 84 as shown in Figure 6. It will be recognized that one or more of these basic building blocks could be orthogonally attached to a substrate (as shown in Figure 2) without an adhesive therebetween.

Referring now to Figure 7, the laminated package 84 (of Figure 6) is then encapsulated in a potting compound such as epoxy and polished to expose the cross section of conductor ends 53.

Figure 8 illustrates a plurality of 3D chip packages 84 mounted on a dielectric carrier or interconnect substrate, such as daughterboard 88. Solder bumps (not shown) are formed on motherboard 88 to correspond with each of the exposed leads emanating from packages 84. The height of the solder bumps can be controlled with standoff spacers 90 in order to ensure optimum solder joint height for maximum reliability.

Figure 9 shows a cross-section enlargement of 3D chip package 84 and daughterboard 88 illustrated in Figure 8. For purposes of illustration, 3D chip package 84 has eight individual S/C chips 92 encapsulated therein and electrical conductors 94 exit from package 84 on the same side to interconnect through the solder joints to daughterboard 88. As illustrated in Figure 9, daughterbard 88 includes multilayers of conductors and insulator material to allow various signals, such as power, ground, x and y-axis signals, to exist therein.

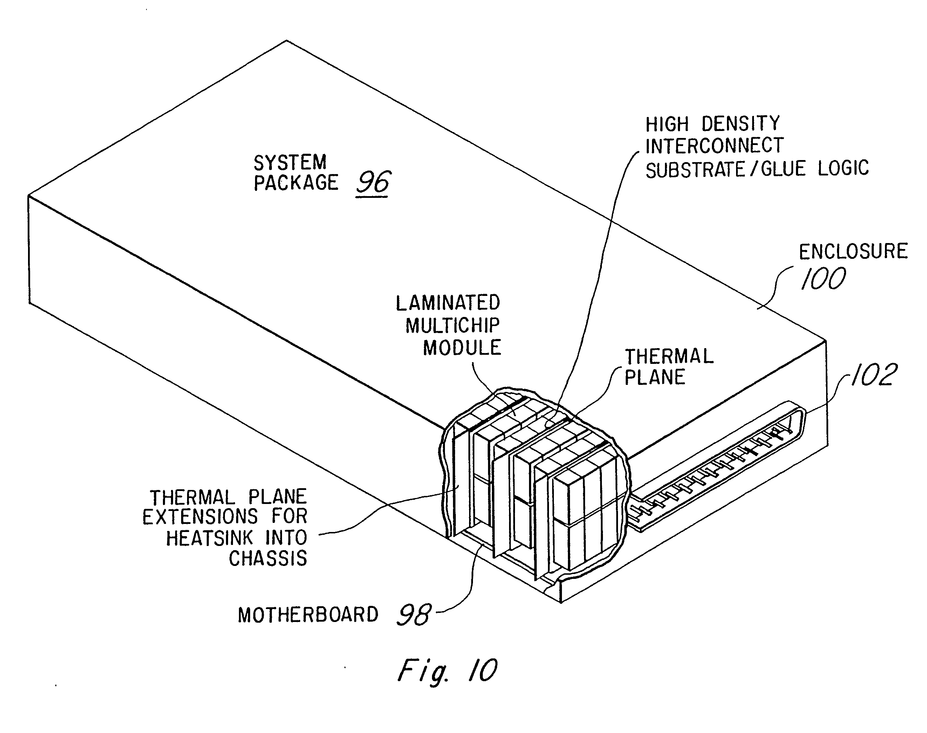

Figure 10 illustrates a system package 96 which includes a plurality of daughterboards 88 (individually shown in Figure 8) which are interconnected by way of motherboard 98. The motherboard is then positioned in an enclosure 100 and the electrical signals input to and output from the motherboard 98 are coupled through connector 102.

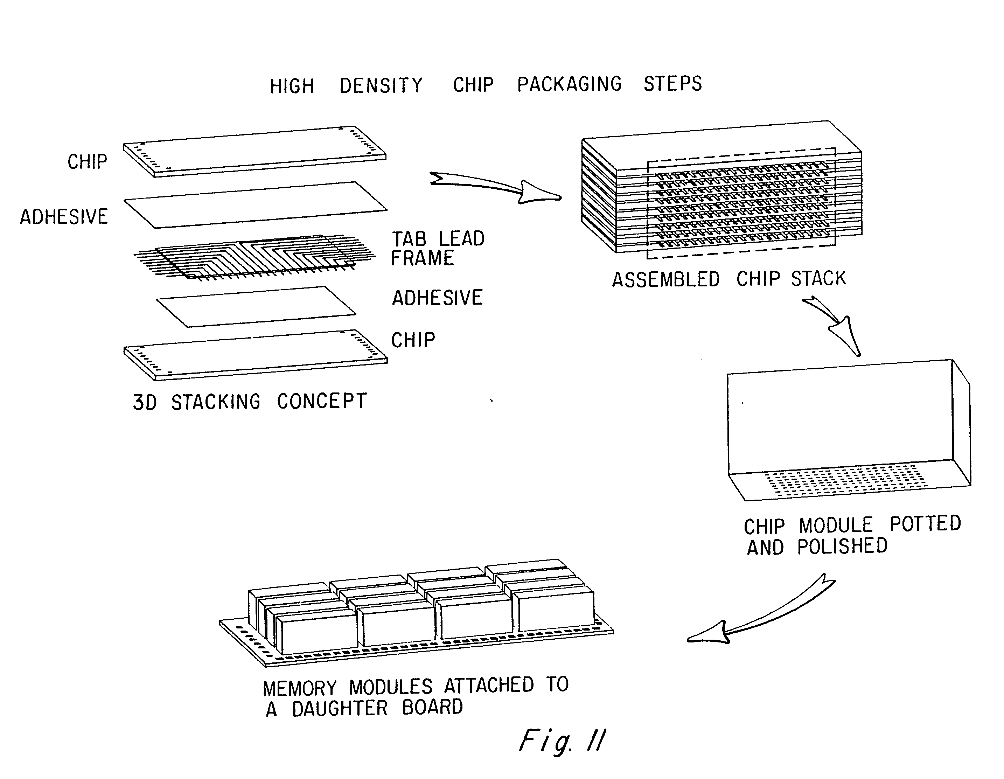

Figure 11 illustrates the packaging steps required to fabricate a 3D chip package according to the present invention. As can be seen from Figure 11, a plurality of chips are laminated together with adhesive and a dielectric carrier having a plurality of conductors mounted thereon all of which exit from the same side. These are then assembled into a chip stack, the chip is encapsulated and polished and then interconnected to a daughterboard. A plurality of these daughterboards are then interconnected to a motherboard (as shown in Figure 10).

Although the present invention has been shown and illustrated in terms of a specific method and apparatus, it will be apparent that changes or modifications can be made without departing from the spirit and scope of the invention as defined by the appended claims.

## Claims

1. A three dimensional package comprising:
a first semiconductor chip having pads on its periphery,
a first dielectric carrier over at least a portion of said first chip, and
a first plurality of conductors positioned on said first carrier and within the periphery of said first chip, one end of said first plurality of conductors connected to the pads while the other end of the conductors exit from the same side of said first chip.

2. A three dimensional package according to claim 1 wherein said first plurality of conductors are positioned between said first chip and said first dielectric carrier.

3. A package according to claim 1 wherein the first dielectric carrier is between the first plurality of conductors and said first chip.

4. A package according to claim 3 further including a first dielectric spacer between said first chip and said first plurality of conductors.

5. A package according to claim 1 further including a second semiconductor chip having second pads on its periphery,
a second dielectric carrier over at least a portion of said second chip, and
a second plurality of conductors positioned on said second carrier and within the periphery of said second chip, one end of said second plurality of conductors connected to said second pads while the other end of said second conductors exit from the same side as those from said first chip.

6. A package according to claim 5 wherein said second dielectric carrier is between said second plurality of conductors and said second chip.

7. A package according to claim 5 further including an interconnect substrate having a plurality of conductive means thereon which electrically interconnect to said first and second plurality of conductors which exit from the same side of said first and second chips.

8. A package according to claim 7 wherein said first and second chips and said interconnect substrate are orthogonal.

9. A three dimensional packaging system comprising:
an interconnect substrate,
a plurality of 3D packages mounted orthogonally on said interconnect substrate, each of said 3D packages comprising:
a first semiconductor chip having first pads on its periphery,
a first dielectric carrier over at least a portion of said first chip, and
a first plurality of conductors positioned on said first carrier and within the periphery of said first chip, one end of said first plurality of conductors connected to said first pads while the other end of the conductors exit from the same side of said first chip,
a second semiconductor chip having second pads on its periphery,
a second dielectric carrier over at least a portion of said second chip, and
a second plurality of conductors positioned on said second carrier and within the periphery of said second chip, one end of said second plurality of conductors connected to said second pads while the other end of said second conductors exit from the same side as those from said first chip.

10. A method of fabricating a three dimensional package including a semiconductor chip having conductive I/O pads along its periphery comprising the steps of:
forming a dielectric carrier sized less than the periphery of said chip,
placing a plurality of conductors on said carrier, one end of said plurality of conductors positioned over said I/O pads while the other ends of said plurality exit from the same side of said chip, and
electrically connecting said conductors exiting from the same side of said chip to an interconnect substrate.

11. A three dimensional package comprising:
a first semiconductor chip having pads on its periphery,
a first dielectric carrier over at least a portion of said first chip, and

a first plurality of conductors positioned on the carrier between said first chip and said first dielectric carrier and within the periphery of said first chip, one end of said first plurality of conductors connected to the pads while the other end of the conductors exit from the same side of said first chip.

12. A package according to claim 11 further including a first dielectric spacer positioned between said first chip and said first plurality of conductors.

13. A package according to claim 11 further including a second semiconductor chip having second pads on its periphery,

a second dielectric carrier over at least a portion of said second chip, and

a second plurality of conductors mounted on the carrier between said second chip and said second dielectric carrier and within the periphery of said second chip, one end of said second plurality of conductors connected to said second pads while the other end of the conductors exit from the same side as those from said first chip.

14. A package according to claim 13 further including an interconnect substrate having a plurality of conductive means thereon which electrically interconnect to said first and second plurality of conductors which exit from the same side of said first and second chips.

15. A method of fabricating a three dimensional package including a semiconductor chip having conductive I/O pads along its periphery comprising the steps of:

forming a dielectric carrier sized less than the periphery of said chip,

affixing a plurality of conductors on said carrier,

positioning said carrier and plurality of conductors over said chip such that said conductors extend parallel to said chip with one end overlaying said conductive pads while the other ends of said plurality exit from the same side of said chip, and

electrically connecting said I/O pads to said one end of said plurality of conductors.

*Fig. 1a* PRIOR ART          *Fig. 1b* PRIOR ART

*Fig. 2*

*Fig. 3*

Fig. 4

Fig. 5

EP 0 354 708 A2

84

SC CHIP

TAPE +
ADHESIVE LAY

SC CHIP

LEADS

53

86

Fig. 6

CROSS SECTION OF
CONDUCTOR ENDS 53
AFTER ENCAPSULATION
AND POLISHING

Fig. 7

84

88

STANDOFFS 90

SOLDER JOINT

*Fig. 8*

92        94        84

8 CHIP PACKAGE

TOP LAYER
GROUND
Y - AXIS SIGNAL
X - AXIS SIGNAL
GROUND
POWER

88

*Fig. 9*

SYSTEM
PACKAGE *96*

HIGH DENSITY
INTERCONNECT
SUBSTRATE / GLUE LOGIC

ENCLOSURE
*100*

LAMINATED
MULTICHIP
MODULE

THERMAL
PLANE

*102*

THERMAL PLANE
EXTENSIONS FOR
HEATSINK INTO
CHASSIS

MOTHERBOARD *98*

*Fig. 10*

EP 0 354 708 A2

# HIGH DENSITY CHIP PACKAGING STEPS

CHIP

ADHESIVE

TAB LEAD
FRAME

ADHESIVE

CHIP

3D STACKING CONCEPT

ASSEMBLED CHIP STACK

CHIP MODULE POTTED
AND POLISHED

MEMORY MODULES ATTACHED TO
A DAUGHTER BOARD

EP 0 354 708 A2

*Fig. 11*